**Europäisches Patentamt**

**European Patent Office**

**Office européen des brevets**

(19)

(11) **EP 1 291 859 A2**

(12) **EUROPEAN PATENT APPLICATION**

(43) Date of publication:
**12.03.2003 Bulletin 2003/11**

(51) Int Cl.$^7$: **G11B 7/26**

(21) Application number: **02020081.2**

(22) Date of filing: **06.09.2002**

(84) Designated Contracting States:
**AT BE BG CH CY CZ DE DK EE ES FI FR GB GR
IE IT LI LU MC NL PT SE SK TR**
Designated Extension States:
**AL LT LV MK RO SI**

(30) Priority: **06.09.2001 JP 2001270697**

(71) Applicant: **TDK Corporation**
**Chuo-ku, Tokyo (JP)**

(72) Inventors:
 • **Oyake, Hisaji**
  **Tokyo (JP)**
 • **Takahata, Hiroaki**
  **Tokyo (JP)**

(74) Representative: **Grünecker, Kinkeldey,
Stockmair & Schwanhäusser Anwaltssozietät
Maximilianstrasse 58
80538 München (DE)**

(54) **Manufacturing method of stamper for optical information medium, photoresist master therefor, stamper for optical information medium and optical information medium**

(57)     A manufacturing method of a stamper for optical information medium comprises forming a photoresist layer on a substrate, irradiating the photoresist layer with laser beam to form a latent image thereon, developing the latent image so that a protrusion/depression pattern is formed to produce a photoresist master, and then transferring the protrusion/depression pattern to a metal film, wherein a photoresist master having an organic material layer provided in contact with the photoresist layer between the substrate and the photoresist layer is used.

# FIG.1

AA3428 5.00kV    1μ    30KX

## Description

Background of the Invention

The present invention relates to a manufacturing method of a stamper for use in the production of an optical information medium having a protrusion/depression pattern such as groove and prepit, a photoresist master therefor, a stamper, and an optical information medium.

Examples of optical information media include an optical recording disc capable of additionally writing or rewriting information thereon, and a disc dedicated to reproduction. An optical recording disc has an information recording layer including phase change layer and organic dye layer formed on a disc substrate. A groove (guide groove) for tracking or the like is provided on the surface of the disc substrate. On the other hand, a disc dedicated to reproduction has a pit having information is integrally formed on the surface of the disc substrate. A metal film, a semimetal film, a dielectric film, etc. are formed on the disc substrate to form an information recording layer.

The disc substrate is produced by injection-molding a resin using a stamper having a master pattern such as pit and groove formed thereon or transferring the pattern of the stamper to a resin. The stamper is normally formed of metal such as Ni. In order to produce such a stamper, a photoresist master which acts as mold for stamper is produced.

The photoresist master is normally produced in the following manner. Firstly, a photoresist layer is formed on thesurfaceofaglasssubstrate. Subsequently, thephotoresist layer is exposed to a patterning beam such as laser beam to form a latent image pattern thereon, and then developed. In this manner, a protrusion/depression pattern is formed on the photoresist layer to obtain a photoresist master.

In order to use this photoresist master to produce a stamper, the photoresist layer is then subjected to sputtering or electroless plating to form a thin film of metal such as Ni so that the surface thereof is rendered electrically conductive . Subsequently, the photoresist layer is subjected to electroforming with the thin metal film as substrate to form an electroformed film of Ni or the like thereon. Subsequently, the laminate of the thin metal film and the electroformed film was peeled off the photoresist layer. This laminate can be used directly as a stamper (master) . However, a mother master may be then produced as a stamper. Such a mother master is produced by forming an electroformed film on the surface of the master, and then peeling the electroformed film off the laminate. The surface of the master has previously been oxidized or otherwise treated so that the electroformed film can be easily peeled. A child master may be produced using the mother master in the same manner as mentioned above. This child master may be used as a stamper.

In the process for producing the photoresist master, the minimum width of the latent image pattern formed on the photoresist layer is restricted by the diameter of the spot of laser beam as an activation energy ray on the surface of the photoresist layer. Assuming that the laser wavelength is $\lambda$ and the numerical aperture of the objective lens in the irradiation optical system is NA, the beam spot diameter w is represented by the equation $w = k \cdot \lambda / NA$ in which k is a constant determined by the shape of aperture of the objective lens and the distribution of intensity of incident light flux.

However, even in the case where a pattern having a width which theoretically doesn't exceed the limit determined by the spot diameter is formed, when the photoresist layer is thin or a pattern having a narrow track pitch is formed, the adhesion of the photoresist layer to the surface of the glass substrate is insufficient. As a result, a problem arises that the unexposed area of the photoresist layer is peeled during development or the patterned photoresist layer is peeled during electroforming, making it impossible to form a desired pattern. Incidentally, the activation energy ray includes not only laser beam but also electron beam.

Summary of the Invention

An object of the invention is to prevent the occurrence of defective stamper due to the peeling of photoresist layer from the photoresist master during manufacturing a stamper for use in the production of an optical information medium.

The aforementioned object of the invention is accomplished by the following constitutions (1) to (6) of the invention.

(1) A manufacturing method of a stamper for optical information medium which comprises forming a photoresist layer on a substrate, irradiating the photoresist layer with laser beam as an activation energy ray to form a latent image thereon, developing the latent image so that a protrusion/depression pattern is formed to produce a photoresist master, and then transferring the protrusion/depression pattern to a metal film, wherein a photoresist master having an organic material layer provided in contact with the photoresist layer between the substrate and the photoresist layer is used.

(2) The manufacturing method of a stamper for optical information medium according to Clause (1), wherein the organic material layer contains a photoresist and the photoresist is heat-cured to a degree such that it no longer acts as a photoresist.

(3) The manufacturing method of a stamper for optical information medium according to Clause (1) or (2), comprising a step of removing a laminate of the photoresist layer and the organic material layer attached to the metal film with a strong alkaline solution after the thin metal film is peeled off the photoresist master after the transfer of the protrusion/depression pattern.

(4) Aphotoresistmaster for use in the process according to any one of Clause (1) to (3).

(5) A stamper for optical information medium produced by the process according to any one of Clause (1) to (3).

(6) An optical information medium comprising a substrate having a protrusion/depression pattern and an information recording layer, wherein the substrate is produced using the stamper for information medium according to Clause (5).

Brief Description of the Drawings

Fig. 1 is a photograph substitute for diagram illustrating a fine pattern formed on a substrate illustrating a scanning type electron microphotograph of a stamper manufactured according to the invention; and

Fig. 2 is a photograph substitute for diagram illustrating a fine pattern formed on a substrate illustrating a scanning type electron microphotograph of a stamper manufactured according to a conventional method.

Detailed Description of the Preferred Embodiment

The stamper for use in the production of an optical information medium is produced by transferring a pattern from the photoresist master as previously mentioned.

In the invention, an organic material layer is provided in contact with the photoresist layer between the substrate and the photoresist layer during the production of the photoresist master.

The organic material layer may be formed by various resins such as thermosetting resin and thermoplastic resin but preferably by a photoresist. The provision of such an organic material layer allows the photoresist layer to be firmly bonded to the organic material layer and the organic material layer to be firmly bonded to the substrate, making it possible to prevent the photoresist layer from peeling off the photoresist master during development or electroforming.

The photoresist to be incorporated in the organic material layer may be the same as or different from the photoresist to be used in the aforementioned photoresist layer. The photoresist to be used in the organic material layer and the photoresist layer may be either a positive-working resist or a negative-working resist. In general, however, the photoresist layer is preferably formed by a positive-working resist. The positive-working resist to be used herein is not specifically limited but may be one containing a resin such as novolac-based resin, a photosensitive material such as naphthoquinone diazide and a solvent.

The organic material layer containing a photoresist is formed by providing a coat layer containing a photoresist, and then baking the coat layer as in the formation of the photoresist layer. The coat layer includes a photoresist and an organic solvent as a solvent of the photoresist. When the coat layer is baked, the photoresist in the coat layer is hardened while the solvent remaining in the coat layer is evaporated. For the formation of the organic material layer, baking is effected more strongly than for the formation of the photoresist layer to enhance the hardening degree. The baking conditions are predetermined such that the photoresist contained in the organic material layer is hardened to an extent such that it no longer acts as a photoresist. In some detail, the organic material layer is heat-cured to an extent such that the organic material layer disposed right under the exposed area of the photoresist layer is no longer dissolved during development. Specific baking conditions differ with the photoresist used. The baking temperature is preferably from 140°C to 240°C, more preferably from 160°C to 220°C. The baking time is preferably from 1 to 40 minutes, more preferably from 5 to 20 minutes. When the organic material layer is insufficiently baked, it acts as a photoresist, making it impossible to exert the effect of the invention and causing mixing at the interface of the organic material layer with the photoresist layer that has an adverse effect on the patterning.

For the formation of the organic material layer, the coating solution may includes various additives such as bonding aid for enhancing the adhesion to the photoresist layer, light absorber and surface active agent incorporated therein as necessary. A coupling agent layer for enhancing the adhesion between the substrate and the organic material layer may be provided between the substrate and the organic material layer.

The thickness of the organic material layer is not specifically limited but may be properly predetermined such that the resulting adhesive strength can be thoroughly enhanced. The thickness of the organic material layer is normally preferably from 1 nm to 300 nm. When the organic material layer is too thin, the resulting adhesive strength can difficultly be thoroughly enhanced. On the contrary, when the organic material layer is remarkably thick, the resulting adhesive strength cannot be remarkably enhanced. Therefore, it is not necessary that the thickness of the organic material layer be greater than the above defined range.

The photoresist layer is subjected to sputtering or electroless plating to form a thin film of metal such as Ni so that the surface thereof is rendered electrically conductive. Subsequently, the photoresist layer is subjected to electroforming with the thin metal film as substrate to form an electroformed film of Ni or the like thereon. Subsequently, the laminate of the thin metal film and the electroformed film is peeled off the photoresist layer. In accordance with the conventional manufacturing method, the substrate of the photoresist master and the photoresist layer are peeled off each other during the peeling of the laminate. Thus, the photoresist layer is left attached to the surface of the laminate . This photoresist layer can be removed with a photoresist stripper.

In the invention, on the contrary, the aforementioned organic material layer having an extremely good adhesion to the photoresist layer is provided. Therefore, when the laminate is peeled, the substrate of the photoresist master and the aforementioned organic material layer are peeled off each other. As a result, the photoresist layer on the laminate is left covered by the aforementioned organic material layer. Even when the photoresist stripper is used under these conditions, the organic material layer cannot be thoroughly removed because the aforementioned organic material layer has a higher hardening rate than the photoresist layer. Further, since the aforementioned organic material layer cannot be thoroughly removed, the photoresist layer disposed between the aforementioned organic material layer and the laminate, too, cannot be thoroughly removed. Thus, when the photoresist layer or organic material layer remains on the laminate, the resulting product has too many defectives to be used as a stamper or its master.

In order to solve these problems, the invention preferably includes peeling the laminate off the photoresist master, and then dipping the laminate in a strong alkaline solution having a higher alkalinity than the photoresist stripper. The aforementioned organic material layer is not dissolved in a strong alkaline solution but the photoresist layer disposed between the organic material layer and the laminate is rapidly dissolved in the strong alkaline solution also at the unexposed area. As a result, the organic material layer can be rapidly removed from the surface of the laminate. As the strong alkaline solution there is preferably used an aqueous solution of NaOH.

In order to apply the invention to produce a photoresist master and a stamper, the same procedure as in the conventional manufacturing method may be followed except that the aforementioned organic material layer is provided and is completely removed during manufacturing the stamper.

Assuming that the wavelength of the laser beam used is $\lambda_E$ and the thickness of the photoresist layer is $t_R$, the invention is remarkably effective when:

$$t_R/\lambda_E \leq 0.6,$$

particularly,

$$t_R/\lambda_E \leq 0.3.$$

Thus, when the thickness of the photoresist layer $t_R/\lambda_E$ relative to the wavelength $\lambda_E$ is small, the photoresist layer can be easily peeled during development and electroforming, particularly during the formation of fine pattern. However, the provision of the aforementioned organic material layer makes it possible to prevent the peeling of the photoresist layer. The relative thickness $t_R/\lambda_E$ is restricted by the width and depth of the protrusion/depression pattern thus formed. In general,

$$0.03 \leq t_R/\lambda_E .$$

Further, assuming that the minimum arrangement pitch of protrusion/depression pattern formed on the photoresist layer is $P_P$, the invention is remarkably effective when:

$$P_P/\lambda_E \leq 1.7,$$

particularly,

$$P_P/\lambda_E \leq 1.0.$$

Thus, when the ratio of the arrangement pitch $P_P$ to the wavelength $\lambda_E$ is small, the photoresist layer can be easily peeled during development and electroforming. However, the provision of the aforementioned organic material layer makes it possible to prevent the peeling of the photoresist layer. When the relative arrangement pitch $P_P/\lambda_E$ is too small, optical restriction prevents the formation of a high precision pattern. Therefore, the relative arrangement pitch $P_P/\lambda_E$ is preferably,

$$0.2 \leq P_P/\lambda_E,$$

more preferably,

$$0.3 \leq P_P/\lambda_E.$$

The protrusion/depression pattern formed on the photoresist layer is a pattern for forming a groove or prepit on a medium. The minimum width in the case where a medium having a groove is produced is the minimum value of the width of a depression portion or protrusion portion forming the groove or land (region present between the grooves).

The wavelength $\lambda_E$ of the laser beam to be used in the invention is not specifically limited. The shorter the wavelength $\lambda_E$ is, the finer is the resulting pattern. Accordingly, the wavelength $\lambda_E$ is preferably small. However, a laser having a remarkably short wavelength can be difficultly realized. Further, a corresponding photoresist can be difficultly developed. Therefore, the wavelength $\cdot\lambda_E$ is preferably from 200 nm to 500 nm, more preferably from 240 nm to 420 nm.

In accordance with the invention, the peeling of the photoresist layer which would occur when the photoresist layer is thin and/or when the resulting pattern is fine can be prevented. Accordingly, a fine pattern which has heretofore not been able to be formed can be formed. For example, when far ultraviolet rays having a wavelength of around 250 nm are used as exposing light, the conventional photoresist master undergoes peeling of the photoresist layer, making it impossible to form a pattern. In accordance with the invention, a pattern free of defectives can be formed. In some detail, a photoresist master for the production of an optical disc having a track pitch of 0.3 μm and a shortest pit length of 0.16 μm can be difficultly produced unless an electron ray resist is used. The application of the invention makes it possible to produce such a photoresist master using far ultraviolet rays. An electron ray exposing device is expensive and cannot withstand vibration. Thus, it takes much trouble to take countermeasure against vibration. Further, such a countermeasure against vibration adds to cost. Accordingly, the invention has a very high industrial value because it can form a pattern having the same fineness as obtained with electron rays without using electron rays.

In the invention, the section of protrusion/depression pattern formed on the photoresist layer may be rectangular, trapezoidal or triangular. For example, in the case where a groove pattern corresponding to the groove on the medium is formed, the section of the groove may be U-shaped or V-shaped. When the photoresist layer is irradiated with laser beam at an intensity high enough to allow it to reach the lower surface of the photoresist layer, a U-shaped groove is formed. When the photoresist layer is irradiated with laser beam at an intensity low enough to prevent it from reaching the lower surface of the photoresist layer, a V-shaped groove is formed. These two kinds of grooves can be present on a photoresist master in combination.

In the invention, the material constituting the substrate from which the photoresist master is prepared is not specifically limited but may be any of glass, metal, semimetal, etc.

Japanese Patent Publication No. H8-227538 discloses an exposure master having a plurality of photoresist layers laminated thereon (photoresist master of the invention). However, unlike the photoresist master of the invention, this exposure master does not exert the effect of the invention because all these plurality of photoresist layers are patterned by exposure and development.

[Example]

EXAMPLE 1

A stamper was produced in the following procedure.

Stamper No. 1

A coupling agent layer was formed on a polished glass substrate. A coat layer of photoresist (TSMR V3, produced by TOKYO OHKA KOGYO CO., LTD.) was then formed on the couprling agent layer by a spin coating method. The coat layer thus formed was then baked at a temperature of 200°C for 15 minutes while the remaining solvent was removed. As a result, an organic material layer was formed to a thickness of 140 nm.

Subsequently, a photoresist (DVR100, produced by NIPPON ZEON Corporation) was spin-coated onto the organic material layer, and then baked to evaporate the remaining solvent to obtain a photoresist layer having a thickness $t_R$ of 30 nm.

Subsequently, using a cutting machine produced by Sony Corporation, the photoresist layer was exposed to Kr laser beam (wavelength $\lambda_E$: 351 nm) for the purpose of forming a groove pattern having an arrangement pitch (minimum arrangement pitch $P_P$ of protrusion/depression pattern) of 320 nm and a width of 150 nm. The photoresist layer was then developed to obtain a photoresist master. Under these conditions,

$$t_R/\lambda_E = 0.085;$$

and

$$P_P/\lambda_E = 0.91.$$

The photoresist master thus obtained was then subjected to electroless plating to form a thin Ni film on the surface of the photoresist layer. Subsequently, the photores ist master was subjected to electroforming with the thin Ni film as substrate to form an electroformed Ni film thereon. Subsequently, the laminate of the organic material layer, the photoresist layer, the thin Ni film and the electroformed Ni film was peeled off the glass substrate. Subsequently, the laminate was dipped in a 20 mass-% aqueous solution of NaOH for 3 minutes so that the photoresist layer was dissolved away, thereby removing the organic material layer too. The laminate was dried, and then punched to a predetermined shape which was then polished on the back side thereof to obtain a stamper No. 1.

Stamper No. 2

A stamper was produced in the same manner as Stamper No. 1 except that no organic material layer was provided.

Evaluation

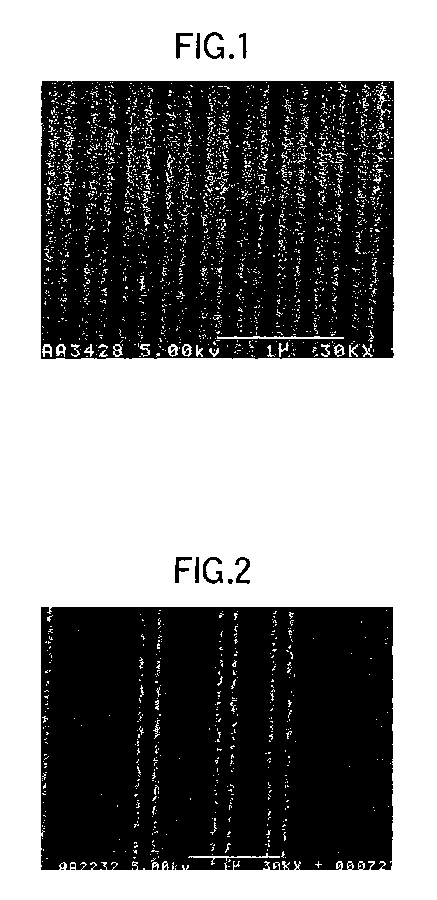

The protrusion/depression pattern formed on the various stampers were each examined for shape under SEM (scanning type electron microscope). Figs. 1 and 2 illustrate SEM image of Stamper No. 1 and Stamper No.2, respectively. In these SEM images, the dark area indicates the recess portion of stamper and the less dark area indicates the protrusion portion of stamper. Accordingly, the dark area corresponds to the protrusion portion (unexposed area) of the photoresist layer and the less dark area corresponds to the recess portion (exposed area) of the photoresist layer.

Figs. 1 and 2 show the effect of the invention. In other words, Stamper No. 1, which was produced according to the invention, had a protrusion portion and an recess portion separated definitely despite its minimum arrangement pitch $P_P$ smaller than the exposing light wavelength $\lambda_E$ and thus had a desired pattern free of defectives. On the contrary, Stamper No. 2, which was produced from a photoresist master without using an organic material layer, were free of many of dark areas which were supposed to be arranged regularly in parallel. This demonstrates that the unexposed area was peeled during the patterning of the photoresist layer.

The laminate of the organic material layer, the photoresist layer, the thin Ni film and the electroformed Ni film was peeled off the glass in the same stamper as Stamper No. 1. Subsequently, the laminate thus peeled was dipped in a photoresist stripper (Stripper-10, produced by TOKYO OHKA KOGYO CO., LTD.). While the organic material layer was completely removed by dipping the laminate in a 20 mass-% aqueous solution of NaOH for 3 minutes in the case of Stamper No. 1, the organic material layer was not removed even after 1 day of dipping in the photoresist stripper. Thus, this product couldn't be used as a stamper.

In the invention, an organic material layer for enhancing adhesion is provided in contact with the photoresist layer during the production of the photoresist master. In this arrangement, the peeling of the photoresist layer can be prevented, making it possible to produce a stamper having a fine pattern faithful to the exposure pattern.

## Claims

1. A manufacturing method of a stamper for optical information medium comprising:

    producing a photoresist master including:

       forming an organic material layer above a substrate;
       forming a photoresist layer on the organic material layer to be provided in contact with the organic material layer;
       irradiating the photoresist layer with an activation energy ray to form a latent image thereon; and

    developing the latent image to form a protrusion/depression pattern; and

    transferring the protrusion/depression pattern to a metal film.

2. The manufacturing method of a stamper for optical information medium as claimed in claim 1, wherein the organic material layer contains a photoresist and the photoresist is heat-cured to an extent such that it no longer acts as a photoresist.

3. The manufacturing method of a stamper for optical information medium as claimed in claim 1, further comprising:

    removing a laminate of the photoresist layer and the organic material layer attached to the metal film with a strong alkaline solution when the thin metal film is peeled off the photoresist master after the transfer of the protrusion/depression pattern.

4. A photoresist master for use in the method as claimed in claim 1.

5. A stamper for optical information medium produced by the method as claimed in claim 1.

6. An optical information medium comprising a substrate having a protrusion/depression pattern and an information recording layer, wherein the substrate is produced using the stamper for information medium as claimed in claim 5.

# FIG.1

# FIG.2